# EUROPÄISCHE PATENTSCHRIFT

(11) **EP 0 953 655 B1**
(45) Veröffentlichungstag und Bekanntmachung des Hinweises auf die Patenterteilung: **12.06.2002**
(21) Anmeldenummer: 99105355.4
(22) Anmeldetag: 16.03.1999
(51) Int. Cl.: C23C 14/28

(54) **Vakuumbeschichtungsanlage**
Vacuum coating apparatus
Dispositif de revêtement sous vide

(30) Priorität: 16.04.1998 DE 19816818
(43) Veröffentlichungstag der Anmeldung: 03.11.1999
(73) Patentinhaber: Bayerische Motoren Werke Aktiengesellschaft, 80788 München (DE)
(72) Erfinder: Schalausky, Robert, 82343 Pöcking (DE); Martin, Dieter, 85368 Wang/Isar (DE)

(56) Entgegenhaltungen:
- WO-A-98/02596
- SCHEIBE H -J ET AL: "DLC FILM DEPOSITION BY LASER-ARC AND STUDY OF PROPERTIES" THIN SOLID FILMS, Bd. 246, Nr. 1/02, 15. Juni 1994 (1994-06-15), Seiten 92-102, XP000453843 ISSN: 0040-6090
- PATENT ABSTRACTS OF JAPAN vol. 012, no. 213 (C-505), 17. Juni 1988 (1988-06-17) & JP 63 011660 A (MITSUBISHI ELECTRIC CORP), 19. Januar 1988 (1988-01-19)

## Beschreibung

Die Erfindung betrifft eine Vakuumbeschichtungsanlage mit einer evakuierbaren Beschichtungskammer für ein zu beschichtendes Substrat und mit zumindest einer hiermit in Verbindung stehenden Quellenkammer für eine Materialquelle für das Beschichtungsmaterial, auf welche ein Laserstrahl von einer außerhalb der Quellenkammer angeordneten Laserstrahlquelle durch ein in der Wand der Quellenkammer vorgesehenes Vakuumfenster gerichtet und dabei mittels einer Ablenkeinheit über die Oberfläche der Materialquelle geführt wird. Zum technischen Umfeld wird neben der DD 279 695 insbesondere auf die WO 98/02596 verwiesen.

Bei der in der letztgenannten Schrift beschriebenen Vakuumbeschichtungsanlage wird Strahlung hoher Leistung aus einem Laser mittels zumindest eines Umlenkspiegels und einer Ablenkeinheit über ein für den Laserstrahl durchlässiges sog. Vakuumfenster in die evakuierte Quellenkammer, in der sich die Beschichtungs-Materialquelle befindet, eingeleitet. Die Laserstrahlquelle, d.h. der Laser sowie der bzw. die Umlenkspiegel und die Ablenkeinheit sind außerhalb der Quellenkammer, d.h. in der Atmosphäre angeordnet. In diesem Zusammenhang sei noch ausdrücklich darauf hingewiesen, daß im folgenden der Begriff "Laserstrahl" für jeden Photonenstrahl hoher Leistung steht, d.h. anstelle einer Laserstrahlquelle kann auch eine andere Photonenstrahlquelle zum Einsatz kommen, die einen Photonenstrahl mit ausreichend hoher Leistung aussendet, um den genannten Beschichtungsprozess durchzuführen, d.h. Beschichtungsmaterial von der Materialquelle abzulösen,

Für den Beschichtungsprozeß ist ein sog. Scannen des Laserstrahles mit Hilfe der genannten Ablenkeinheit über der Materialquelle erforderlich, d.h. die Ablenkeinheit führt den Laserstrahl bevorzugt längs eines geraden Striches über die Oberfläche der Materialquelle, so daß der Laserstrahl stets eine Ebene beschreibt. Dabei ist diese Materialquelle in Form einer rotierenden Walze ausgebildet. Wird dann zwischen diese rotierende Materialquellen-Walze und weiterhin in der Quellenkammer vorgesehenen Elektroden eine elektrische Spannung angelegt, so kann mit Hilfe des gepulsten Laserstrahles zwischen den Elektroden und der Materialquellen-Walze ein Entladungsbogen gezündet werden. Um dabei eine lokale Erhitzung der Materialquelle zu vermeiden, wird der Laserstrahl wie bereits erwähnt mit Hilfe der Ablenkeinheit als geradliniger Strich parallel zur Walzenachse der Materialqueilen-Walze kontinuierlich über die Oberfläche dieser dabei rotierenden Walze geführt.

In dem Entladungsbogen bzw. dem Entladungsplasma zwischen der als Materialquelle fungierenden und demzufolge aus dem gewünschten Beschichtungsmaterial bestehenden Walze und der bereits genannten Gegen-Elektrode(n) werden nun die aus der Walze herausgelöste Atome in einem hohen Prozentsatz nachionisiert. Die ionisierten Atome bzw. Moleküle, d.h. Ionen werden zwischen der Walze und der/den Elektrode(n) auf eine der hierzwischen angelegten elektrischen Spannung entsprechende Geschwindigkeit beschleunigt und fliegen in dieser Quellenkammer und in der sich daran anschließenden Beschichtungskammer weiter, bis sie auf den sich in letzterer befindenden Substraten oder auf den (innenseitigen) Wänden der Quellenkammer und der Beschichtungskammer auftreffen. Dabei fliegen insbesondere diejenigen aus der Materialguellen-Walze herausgelösten Teilchen oder Atome bzw. Moleküle, die nicht in den Bereich zwischen Walze und Elektrode(n) gelangen, wegen der fehlenden lonisierung im Plasmabereich mit niedrigerer Teilchenenergie auf die (innere) Kammerwand der Quellenkammer.

Längerfristig betrachtet wird sich somit auf der Innenwand der Quellenkammer eine Schicht des von der Materialquellen-Walze abgelösten Beschichtungsmateriales bilden, was an sich unproblematisch ist. Jedoch bildet sich eine derartige Schicht auch auf der Innenseite des Vakuumfensters der Quellenkammer aus. Dies ist insofern ein gravierendes Problem, als hierdurch die Durchlässigkeit dieses Fensters für den Laserstrahl zumindest längerfristig betrachtet erheblich eingeschränkt wird. Tatsächlich muß nämlich auf diesem Vakuumfenster zumindest ein gewisser strichförmiger Bereich (wegen der beschriebenen geradlinigen Bewegung des Laserstrahles über der Oberfläche der Materialquellen-Walze) frei bleiben, da andernfalls der Laserstrahl die Materialquellen-Walze nicht bzw. nur noch mit reduzierter und somit nicht ausreichender Leistung erreichen würde.

Eine Maßnahme aufzuzeigen, die der Lösung dieses geschilderten Problemes gerecht wird, ist Aufgabe der vorliegenden Erfindung.
Die Lösung dieser Aufgabe ist dadurch gekennzeichnet, daß in der Quellenkammer in Strahlrichtung des Laserstrahles betrachtet hinter dem Vakuumfenster eine mittels zumindest eines Stellmotors positionierbare Blende für den Laserstrahl vorgesehen ist, deren Position an die aktuelle Strahlrichtung durch Korrelation mit der Ablenkeinheit angepaßt wird. Vorteilhafte Aus- und Weiterbildungen sind Inhalt der Unteransprüche.

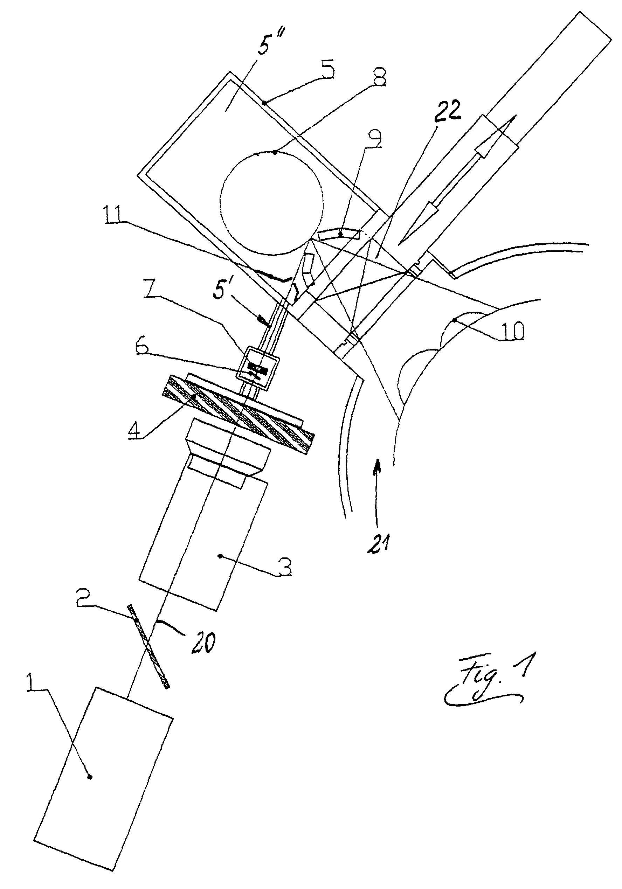

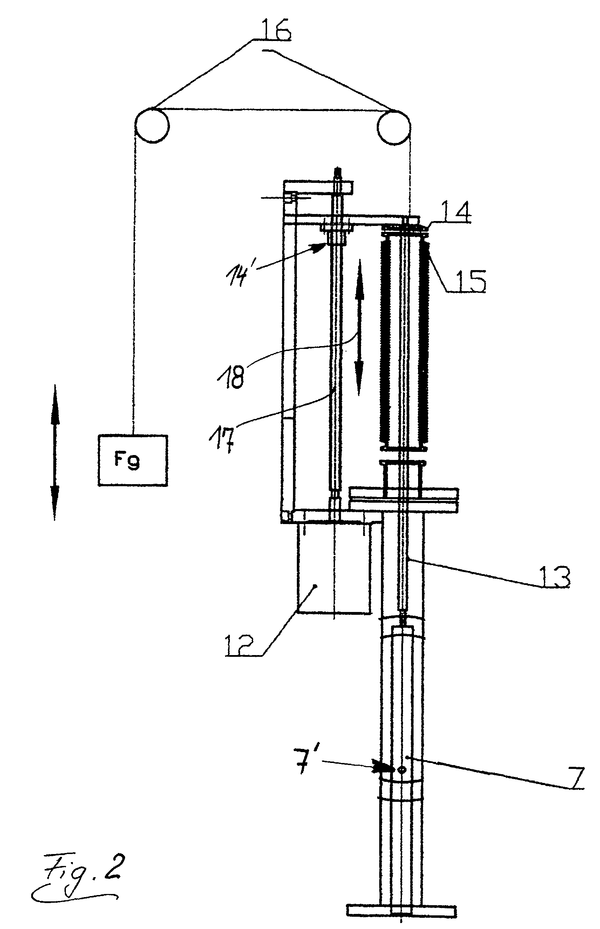

Näher erläutert wird die Erfindung anhand eines bevorzugten Ausführungsbeispieles, welches in den beiden beigefügten Figuren abstrahiert dargestellt ist. Dabei zeigt Fig. 1 die Gesamtanordnung der Vakuumbeschichtungsanlage bzw. zumindest die wesentlichen Elemente hiervon, während in Fig. 2 ein bevorzugtes Ausführungsbeispiel für die Positioniereinrichtung der erfindungswesentlichen Blende dargestellt ist.

Mit der Bezugsziffer 1 ist eine Laserstrahlquelle bezeichnet, die in der hier beschriebenen Versuchsanlage als Infrarot-Laser ausgebildet ist. Ein von dieser Laserstrahlquelle 1 ausgesendeter Laserstrahl 20 wird mittels eines Umlenkspiegels 2 und einer Ablenkeinheit 3 über ein für den Laserstrahl 20 durchlässiges Vakuumfenster 4 in eine evakuierte bzw. evakuierbare Quellenkammer 5 eingekoppelt, wobei sich das Vakuumfenster 4 in der Wand der Quellenkammer 5 befindet.

In der Quellenkammer 5 gelangt der Laserstrahl 20 zunächst durch eine einfach auswechselbare und für die betreffende Strahlung durchlässige Schutzglasscheibe 6, die in einem beliebigen Winkel zum Strahlengang des Laserstrahles 20 angeordnet sein kann. Dabei kann die Transmission bzw. die Strahldurchlässigkeit des Vakuumfensters 4 und/oder der Schutzglasscheibe 6 durch eine speziell auf die Wellenlänge des Laserstrahles 20 abgestimmte Beschichtung erhöht sein.

Nach Durchdringen der Schutzglasscheibe 6 läuft der Laserstrahl 20 in der Quellenkammer und somit im Vakuum weiter durch eine Blende 7 und passiert danach sogenannte Droplett-Fangbleche 11, die bereits in der eingangs genannten DD 279 695 beschrieben sind, ehe er auf eine Materialquelle 8 für das Beschichtungsmaterial auftrifft.

In der Quellenkammer 5 ist an die Materialquelle 8 eine elektrische Spannung angelegt, deren Gegenpol bzw. Gegenspannung an hier zwei ebenfalls in der Quellenkammer 5 vorgesehenen Elektroden 9 anliegt. In der hier beschriebenen Versuchs-Beschichtungsanlage ist die als rotierende Walze ausgebildete Materialquelle 8 als Kathode und die statisch angeodnete Gegen-Elektrode 9 als Anode ausgelegt. Mit Hilfe des gepulsten Laserstrahls 20 wird dann zwischen der Kathode bzw. Materialquelle 8 und der Anode bzw. den Elektroden 9 ein Entladungsbogen gezündet. Dabei wird - wie bereits in der Einleitung beschrieben - zur Vermeidung einer lokalen Erhitzung der Materialquelle 8 der Laserstrahl 20 mit Hilfe eines geeigneten Laserspiegels in der Ablenkeinheit 3 als geradliniger Strich parallel zur Materialquellen-Walze (diese wird im folgenden ebenfalls mit der Bezugsziffer 8 bezeichnet) kontinuierlich über die Oberfläche dieser rotierenden Materialquellen-Walze 8 geführt.

In dem Entladungsplasma zwischen der Materialquellen-Walze 8 und den Gegen-Elektroden 9 werden aus der Materialquelle 8 herausgelöste Atome bzw. Moleküle in einem hohen Prozentsatz nachionisiert. Die ionisierten Atome/Moleküle (lonen) werden zwischen der Kathode (= Materialquelle 8) und der Anode (= Elektroden 9) auf eine der hierzwischen angelegten Spannung entsprechende Geschwindigkeit beschleunigt und fliegen in die sich an die Quellenkammer 5 anschließende Beschichtungskammer 21 weiter, wo sie auf das (oder den) sich dort befindende(n) Substrat(en) 10 auftreffen, was den eigentlichen Beschichtungsvorgang dieses/dieser Substrate(s) 10 darstellt. Dabei ist zwischen der Quellenkammer 5 und der Beschichtungskammer 21 eine Schleuse 22 vorgesehen, was für das Wesen der vorliegenden Erfindung jedoch unerheblich ist.

In der Beschreibungseinleitung wurde bereits die Problematik angesprochen, daß sich ein Teil der aus der Materialquelle 8 herausgelösten Atome/Moleküle auch an den Innenwänden der Quellenkammer 5 niederschlägt, so daß die Tendenz besteht, daß auch die Innenseite des Vakuumfensters 4 mit diesem Material beschichtet wird. Dies gilt es jedoch zu vermeiden, da dies zu einer verringerten Durchlässigkeit für den Laserstrahl 20 und führt wodurch dessen Leistung vermindert wird, so daß dieser Laserstrahl 20 nach einiger Zeit (in Versuchen handelte es sich hierbei um wenige Minuten) überhaupt nicht mehr auf der Materialquellen-Walze 8 auftreffen kann.

Verschiedene Maßnahmen sind vorgesehen, um diesem Problem zu begegnen. Zum einen ist der sich direkt an das Vakuumfenster 4 anschließende Teilbereich der Quellenkammer 5 wie ersichtlich kanalartig eng ausgebildet, ehe sich dieser Kanalabschnitt 5' der Quellenkammer 5 in den eigentlichen Kammerraum 5", in welchem sich die Materialquellen-Walze 8 befindet, erweitert. Mit dieser Maßnahme konnte jedoch keine deutlich merkbare Verbesserung festgestellt werden.

Vorgesehen ist in der Quellenkammer 5 und genauer im Übergangsbereich vom Kanalabschnitt 5' in den eigentlichen Kammerraum 5" das bereits erwähnte und auch bereits in der eingangs genannten DD 279 695 beschriebene Droplet-Fangblech 11, welches so angeordnet ist, daß möglichst wenig ausgelöste Teilchen der Materialquelle 8 das sich am dem Kammerraum 5" abgewandten Ende des Kanalabschnittes 5' befindende Vakuumfenster 4 erreichen können. Auch mit dieser Maßnahme konnte jedoch keine aureichende Verbesserung der geschilderten Problematik, nämlich des Niederschlages von Beschichtungsmaterial auf der Innenseite des Vakuumfensters 4, festgestellt werden.

Um den unerwünschten Niederschlag von Beschichtungsmaterial auf dem hochwertigen und folglich teueren Vakuumfenster 4 zu vermeiden, ist in der Quellenkammer 5 bzw. genauer im Kanalabschnitt 5' hinter dem Vakuumfenster 4 eine Schutzglasscheibe 6 vorgesehen. Insbesondere bei der beschriebenen Verwendung des Lasers 1 als Strahlenquelle 1 würde nämlich eine auf der vakuumseitigen Oberfläche des Vakuumfensters 4 erfolgende Schichtbildung von Beschichtungsmaterial durch die Erniedrigung der Transmission einen Rückgang der in die Quellenkammer 5 eingebrachten Laser-Leistung bewirken und somit zum einen eine nachteilige Veränderung des Beschichtungsprozesses darstellen. Eine sich auf dem Vakuumfenster 4 bildende Schicht würde jedoch darüberhinaus wegen der Verringerung des Transmissionsgrades gezwungenermaßen eine Erhöhung des Reflexionsgrades des Vakuumfensters 4 verursachen. Eine erhöhte Reflexion hätte zur Folge, daß bei bestimmten Geometrien von Linsen und Spiegeln im optischen System des Lasers 1 der ausgesandte Laserstrahl 20 auf ein optisches Element in der Laserstrahlquelle fokussiert zurück gespiegelt würde. Dies könnte dann infolge der hohen Laserleistung eine Verletzung des optischen Systems des Lasers 1 und den Abbruch des gesamten Beschichtungsprozesses zur Folge haben.

Mit dem Vorsehen der Schutzglasscheibe 6 kann zumindest die soeben geschilderte Problematik gelöst werden, insbesondere dann, wenn die Schutzglasscheibe 6 derart angeordnet ist, daß jede (durch die Ablenkeinheit 3) erzeugbare Strahlrichtung des Laserstrahles 20 nicht senkrecht auf deren Scheibenebene auftrifft. In der beigefügten Figurendarstellung ist der Laserstrahl 20 in einer zur Zeichenebene senkrechten Ebene bewegbar, und demzufolge ist - um eine exakte Rückspiegelung des Laserstrahles 20 in den Laser 1 zu verhindern - die Schutzglasscheibe 6, welche die von der Materialquelle 8 abgelösten Teilchen auffängt, nicht rechtwinklig zum Strahlengang des Laserstrahles 20 angeordnet.

Weiterhin noch nicht behoben ist mit dem Vorsehen der Schutzglasscheibe 6 jedoch das Beschlagproblem als solches, da sich nun eben der Niederschlag von losgelösten Materialquellen-Teichen auf der Innenseite der Schutzglasscheibe 6 und nicht mehr auf dem Vakuumfenster 4 bildet. Aus diesem Grunde ist zusätzlich vorgesehen, daß die gegenüber dem Vakuumfenster 4 einfachere und somit weniger teuere Schutzglasscheibe 6 auf relativ einfache Weise austauschbar ist und insbesondere einfacher austauschbar ist als das Vakuumfenster 4 selbst.

Um nun auch den Niederschlag von losgelösten Materialquellen-Teichen auf der Innenseite der Schutzglasscheibe 6 so gering als möglich zu halten, so daß die austauschbare Schutzglasscheibe 6 so selten als möglich ausgetauscht werden muß, ist in Strahlrichtung des vom Laser 1 ausgesendeten Laserstrahles 20 möglichst direkt hinter der Schutzglasscheibe 6 eine der Bewegung des Laserstrahls 20 angepaßte Blende 7 installiert. Bei dieser Blende 7 handelt es sich bevorzugt um eine Metallplatte bspw. aus Aluminium, welche mit einer Bohrung 7' (vgl. hierzu Fig. 2) versehen ist, wobei der Durchmesser dieser Bohrung 7' in der Metallplatte bzw. in der Blende 7 nur unwesentlich größer als die Laserstrahlgröße bzw. der Durchmesser des Laserstrahles 20 am Ort der Blende 7 ist.

Diese Blende 7 ist nun - wie bereits erwähnt - derart bewegbar installiiert und dabei mittels eines Stellmotors 12 (vgl. auch hierzu die später noch erläuterte Fig. 2) positionierbar, daß ihre Position an die aktuelle Strahlrichtung des Laserstrahles 20 durch Korrelation mit der Ablenkeinheit 3 für den Laserstrahl 20 angepaßt wird. In anderen Worten ausgedrückt bedeutet dies, daß sich die Blende 7 bzw. genauer die darin befindliche Bohrung 7' stets dort befindet, wo der Laserstrahl 20 seinen Weg nimmt, so daß er stets durch die Bohrung 7' in der Blende 7 hindurchtreten kann, während der die besagte Bohrung 7' umgebende Flächenbereich des Kanalabschnittes 5' der Quellenkammer 5 vom undurchlässigen Metallplattenabschnitt der Blende 7 abgedeckt wird. Die in der Quellenkammer 5 frei umherschwirrenden Teilchen des von der Materialquelle 8 abgelösten Beschichtungsmaterials prallen somit an der Blende 7 bzw. an deren Metallplatte ab und werden hierdurch davon abgehalten, zur Schutzglasscheibe 6 zu gelangen.

Um somit - wie beschrieben - der jeweiligen Lage des Laserstrahles 20 (in der Figurendarstellung in einer zur Zeichenbene senkrechten Ebene) folgen zu können, wird die Blende 7 mit zumindest einem Stellmotor 12 positioniert. Der Antrieb dieses oder der ggf. mehreren Stellmotoren 12 ist dabei mit den elektronischen Ausgängen der Ablenkeinheit 3 korreliert, so daß sich die Blende 7 mit Hilfe ihres Antriebs synchron mit dem Spiegel der Ablenkeinheit 3 des Lasersystemes bewegt. Hiermit wird gewährleistet, daß zu jedem Zeitpunkt des Beschichtungsprozesses nur derjenige Teil des Vakuumfensters 4 sowie der Schutzglasscheibe 6 von der Blende 7 bzw. von der darin befindlichen Bohrung 7' freigegeben wird, der auch gerade für den Durchgang des Laserstrahles 20 benötigt wird.

Wie Fig. 2 zeigt, ist die Blende 7 ist über eine starre Achse 13 mit einem sog. Vakuumflansch 14 verbunden, der den Abschlußflansch eines Membranbalges 15 darstellt, so daß dieser Vakuumflansch 14 über den hochflexiblen metallischen Membranbalg 15 mit der Quellenkammer 5 bzw. genauer dem Kanalabschnitt 5' derselben in Verbindung steht. Der sog. Vakuumflansch 14 weist einen als Schraubenmutter mit einem Gewinde versehenen Abschnitt 14' auf, der auf einer mit einem entsprechenden Gegengewinde versehenen Kugelumlaufspindel 17 geführt ist, welche ihrerseits vom Stellmotor 12 in Rotation versetzt wird bzw. werden kann. Mit einer Rotation dieser Kugelumiaufspindel 17 wird somit der Vakuumflansch 14 und demzufolge über die starre Achse 13 auch die Blende 7 gemäß Pfeilrichtung 18 verfahren. Hierdurch kann somit - initiiert durch den Stellmotor 12 - die Blende 7 bzw. deren Bohrung 7' wie gewünscht positioniert werden.

Dabei wird der durch den Unterdruck (dieser liegt in der Größenordnung von 10⁻⁵ mbar) in der Quellenkammer 5 ausgeübte Druck auf den Vakuumflansch 14 des Membranbalges 15 mittels einer geeigneten Kompensationsmechanik 16 ausgeglichen, so bspw. wie hier symbolisch dargestellt durch ein Gegengewicht (mit Fg bezeichnet) und/oder durch Zug- bzw. Druckfedern.

Die der Strahlenquelle 1 zugewandte Oberfläche der Blende 7 ist derart gestaltet, daß jede erzeugbare Strahlrichtung des Laserstrahles 20 nicht senkrecht auf deren Oberfläche auftrifft, so daß evtuelle nachteilige Reflexionen des Laserstrahles 20 an der Blende 7 bzw. an der Metallplatte zurück in den Laser 1 vermieden werden. Hierzu kann die der Laserstrahlquelie 1 zugewandte Seite der Blende 7 bspw. mit schrägen Ausfräsungen, wie Kerben mit 45° Sägezahnprofil, versehen sein (nicht gezeigt).

Nicht nur das Vakuumfenster 4, sondern auch die Schutzglasscheibe 6 können oberflächenseitig mit Entspiegelungsschichten versehen sein. Die daraus resultierende hohe Transmission von bspw. 99,4% gegenüber üblichen 92% erhöht den Wirkungsgrad und verhindert insbesondere weitestgehend Reflexionen des Laserstrahles 20 zurück in den Laser 1.

Zusammenfassend läßt sich feststellen, daß mit den beschriebenen erfindungsgemäßen Maßnahmen eine unerwünschte Beschichtung des Vakuumfensters 4 mit dem an der Materialquelle 5 freigesetzten Beschichtungsmaterial total unterbunden wird. Auch die zusätzlich in den Strahlengang des Lasers 1 eingebrachte Schutzglasscheibe 6 wird wegen der dem Laserstrahl 20 synchron folgenden Blende 7 kaum und dabei insbesondere nur an derjenigen Stelle (unerwünschterweise) beschichtet, an der gerade in dem Moment der Laserstrahl 20 hindurchtritt. Infolge der hohen Laserleistung und der ohnehin geringen Haftung der Schicht aus neutralen Teilchen des Beschichtungsmaterials wird dabei die Aufwachsrate der Schicht an der mit Laserlicht bestrahlten Stelle weiter reduziert. Durch diese eklatante Verbesserungen wird somit die Standzeit einer erfindungsgemäßen Vakuum-Beschichtungsanlage entscheidend verlängert und die Reparatur- bzw. Wartungszeiten auf ein Minimum begrenzt, wobei abschließend noch darauf hingewiesen sei, daß eine Vielzahl von Details insbesondere konstruktiver Art durchaus abweichend vom gezeigten Ausführungsbeispiel gestaltet sein können, ohne den Inhalt der Patentansprüche zu verlassen, und daß die beschriebenen Verbesserungen selbstverständlich auch für an Atmosphärendruck arbeitende Beschichtungsverfahren eingesetzt werden können (nicht erfindungsgemäß).

### Bezugszeichenliste:

- 1: Laserstrahlquelle / Laser
- 2: Umlenkspiegel
- 3: Ablenkeinheit
- 4: Vakuumfenster
- 5: Quellenkammer
- 5': Kanalabschnitt (von 5)
- 5": Kammerraum (von 5)
- 6: Schutzglasscheibe
- 7: Blende
- 7': Bohrung in 7
- 8: Materialquelle / Materialquellen-Walze
- 9: Elektrode(n)
- 10: (zu beschichtendes) Substrat
- 11: Droplet-Fangbleche
- 12: Stellmotor
- 13: starre Achse
- 14: Vakuumflansch
- 14': Abschnitt von 14: Schraubenmutter
- 15: Membranbalg
- 16: Kompensationsmechanik
- 17: Kugelumlaufspindel
- 18: Pfeilrichtung
- 20: Laserstrahl / Laserstrahl
- 21: Beschichtungskammer
- 22: Schleuse (zwischen 5 und 21)

## Patentansprüche

1. Vakuumbeschichtungsanlage mit einer evakuierbaren Beschichtungskammer (21) für ein zu beschichtendes Substrat (10), und mit zumindest einer hiermit in Verbindung stehenden Quellenkammer (5) für eine Materialquelle (8) für das Beschichtungsmaterial, auf welche ein Laserstrahl (20) von einer außerhalb der Quellenkammer (5) angeordneten Laserstrahlquelle (1) durch ein in der Wand der Quellenkammer (5) vorgesehenes Vakuumfenster (4) gerichtet und dabei mittels einer Ablenkeinheit (3) über die Oberfläche der Materialquelle (8) geführt wird,
**dadurch gekennzeichnet, daß** in der Quellenkammer (5) in Strahlrichtung des Laserstrahles (20) betrachtet hinter dem Vakuumfenster (4) eine mittels zumindest eines Stellmotors positionierbare Blende (7) für den Laserstrahl (20) vorgesehen ist, deren Position an die aktuelle Strahlrichtung durch Korrelation mit der Ablenkeinheit (3) angepaßt wird.

2. Vakuumbeschichtungsanlage nach Anspruch 1,
**dadurch gekennzeichnet, daß** in der Quellenkammer (5) in Strahlrichtung des Laserstrahles (20) betrachtet hinter dem Vakuumfenster (4) und vor der Blende (7) eine austauschbare Schutzglasscheibe (6) derart angeordnet ist, daß jede erzeugbare Strahlrichtung nicht senkrecht auf deren Scheibenebene auftrifft.

3. Vakuumbeschichtungsanlage nach Anspruch 1 oder 2,
**dadurch gekennzeichnet, daß** die Blende (7) als eine Metallplatte mit einer Bohrung (7') ausgebildet ist, deren Durchmesser nur unwesentlich größer als der Durchmesser des Laserstrahles (20) im Bereich der Blende (7) ist.

4. Vakuumbeschichtungsanlage nach einem der vorangegangenen Ansprüche,
**dadurch gekennzeichnet, daß** die der Laserstrahlquelle (1) zugewandte Oberfläche der Blende (7) derart gestaltet ist, daß der Laserstrahl (20) nicht senkrecht auf die Oberfläche auftrifft.

5. Vakuumbeschichtungsanlage nach einem der vorangegangenen Ansprüche,
**dadurch gekennzeichnet, daß** die Oberfläche der Schutzglasscheibe (6) und des Vakuumfensters (4) mit einer Entspiegeiungsschicht versehen ist.

## Claims

1. A vacuum coating installation comprising an evacuatable chamber (21) for a substrate (10) for coating and connected to at least one chamber (5) for a source (8) of the coating material, on to which a laser beam (20) is directed by a source (1) outside the chamber (5) through a vacuum window (4) in the wall of the chamber (5) and guided by a deflecting unit (3) over the surface of the source (8) of material,
**characterised in that** a shutter (7) for the laser beam (20) positionable by at least one servomotor is provided in the source chamber (5) behind the vacuum window (4) as considered in the direction of the laser beam (20), the position of the shutter being adapted to the actual direction of the beam by correlation with the deflecting unit (3).

2. A vacuum coating installation according to claim 1,
**characterised in that** an interchangeable protective glass plate (6) is so positioned in the source chamber (5) in front of the shutter (7) and behind the vacuum window (4) in the direction of the laser beam (20) that no possible direction of the beam is at right angles to the plane of the plate.

3. A vacuum coating installation according to claim 1 or claim 2,
**characterised in that** the plate (7) is a metal plate formed with a bore (7') having a diameter only slightly greater than the diameter of the laser beam (20) in the region of the shutter (7).

4. A vacuum coating installation according to any of the preceding claims,
**characterised in that** the surface of the shutter (7) facing the laser-beam source (1) is shaped so that the laser beam (20) does not strike the surface at right angles.

5. A vacuum coating installation according to any of the preceding claims,
**characterised in that** the surface of the protective glass plate (6) and of the vacuum window (4) is coated with an anti-reflection layer.

## Revendications

1. Installation de revêtement sous vide comportant une chambre de revêtement (21) mise sous vide pour recevoir un substrat (10) à revêtir et au moins une chambre à source (5) mise en communication avec celle-ci pour recevoir une source de matière de revêtement (8) sur laquelle est dirigé un faisceau laser (20) d'une source laser (1) installée à l'extérieur de la chambre (5) contenant la source, et qui traverse une fenêtre sous vide (4) installée dans la paroi de la chambre (5) de la source, en balayant la surface de la source de matière (8) sous l'action d'une unité de déflexion (3),
**caractérisée en ce que**
dans la chambre (5) contenant la source, derrière la chambre sous vide (4), par rapport à la direction du faisceau laser (20), il est prévu un diaphragme (7) positionné par au moins un actionneur pour le faisceau laser (20), la position du diaphragme étant adaptée à la direction instantanée du faisceau en corrélation avec l'unité déflectrice (3).

2. Installation de revêtement sous vide selon la revendication 1,
**caractérisée en ce que**
dans la chambre (5) contenant la source, ou dans la direction du faisceau laser (20), en aval de la fenêtre sous vide (4) et devant le diaphragme (7), il est prévu une vitre (6) remplaçable, cette vitre étant installée pour que, quelle que soit la direction du faisceau, il n'arrive pas perpendiculairement sur le plan de la vitre.

3. Installation de revêtement sous vide selon l'une des revendications 1 ou 2,
**caractérisée en ce que**
le diaphragme (7) est réalisé sous forme d'une plaque métallique avec un perçage (7') dont le diamètre n'est que légèrement supérieur au diamètre du faisceau laser (20) au niveau du diaphragme (7).

4. Installation de revêtement sous vide selon l'une des revendications précédentes,
**caractérisée en ce que**
la surface du diaphragme (7) tournée vers la source laser (1) est réalisée pour que le faisceau laser (20) ne rencontre pas la surface dans une direction perpendiculaire.

5. Installation de revêtement sous vide selon l'une des revendications précédentes,
**caractérisée en ce que**
la surface de la vitre protectrice (6) et de la fenêtre sous vide (4) sont munies d'une couche anti-réfléchissante.
